# EUROPEAN PATENT SPECIFICATION

(11) **EP 1 478 012 B1**
(45) Date of publication and mention of the grant of the patent: **01.08.2007**
(21) Application number: 03705360.0
(22) Date of filing: 20.02.2003
(51) Int. Cl.: H01L 21/304, B24B 37/00, C09K 3/14, B24B 37/04, B24B 7/22, C09G 1/00

(54) **POLISHING METHOD AND POLISHING FLUID**
POLIERVERFAHREN UND POLIERFLÜSSIGKEIT
PROCEDE DE POLISSAGE ET FLUIDE DE POLISSAGE

(30) Priority: 20.02.2002 JP 2002043471
(43) Date of publication of application: 17.11.2004
(73) Proprietor: EBARA CORPORATION, Ohta-ku, Tokyo 144-8510 (JP); KAO CORPORATION, Tokyo 103-8210 (JP)
(72) Inventor: WADA, Yutaka, Tokyo 144-8510 (JP); AKATSUKA, Tomohiko, Tokyo 144-8510 (JP); SASAKI, Tatsuya, Tokyo 144-8510 (JP); HAGIHARA, Toshiya, Wakayama-shi, Wakayama 640-8580 (JP)
(74) Representative: Wagner, Karl H.
(86) International application number: PCT/JP2003/001870
(87) International publication number: WO 2003/071593

(56) References cited:
- WO-A1-97/10613
- WO-A1-98/18159
- JP-A- 2000 173 955
- JP-A- 2002 043 256
- US-A- 5 990 012
- US-A- 6 066 028
- US-A1- 2002 160 609
- PATENT ABSTRACTS OF JAPAN vol. 2002, no. 06, 4 June 2002 (2002-06-04) & JP 2002 043256 A (HITACHI LTD), 8 February 2002 (2002-02-08) & US 2002/028581 A1 (YASUI KAN ET AL) 7 March 2002 (2002-03-07)

## Description

### Technical Field

The present invention relates to a polishing method and a polishing liquid, and more particularly to a polishing method and a polishing liquid for polishing a workpiece such as a semiconductor wafer with a fixed abrasive.

### Background Art

As semiconductor devices become more highly integrated in recent years, circuit interconnections have become finer and distance between those circuit interconnections becomes smaller. In case of photolithography which can form interconnections that are at most 0.5 µm wide, it is required that surfaces on which pattern images are to be focused by a stepper should be as flat as possible because a depth of focus of an optical system is relatively small. A polishing apparatus for performing chemical mechanical polishing (CMP) has been used for planarizing a semiconductor wafer.

This type of chemical mechanical polishing (CMP) apparatus comprises a polishing table having a polishing pad attached thereon, and a top ring. A workpiece to be polished is disposed between the polishing pad and the top ring and pressed against the polishing table by the top ring, while a polishing liquid (slurry) is being supplied onto the polishing pad, and hence the workpiece is polished to a flat mirror finish.

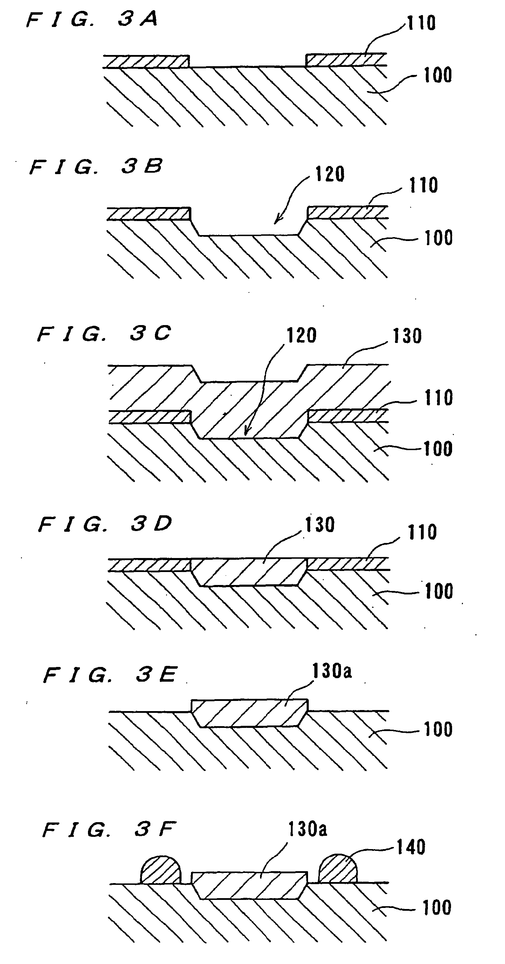

The CMP apparatus is used in an STI (Shallow Trench Isolation) forming process for forming a transistor circuit on a lowermost layer of a semiconductor device, for example. FIGS. 3A through 3F are schematic cross-sectional views showing an example of the STI forming process. A nitride film 110 (generally, a film of silicon nitride Si₃N₄) is formed on a silicon substrate 100 (see FIG. 3A), and the silicon substrate 100 is etched using the nitride film 110 as a mask, thus forming a trench (groove) 120 (see FIG. 3B). Then, a silicon oxide film 130 made of an insulating material is embedded in the trench 120 (see FIG. 3C).

When the silicon oxide film 130 is embedded in the trench 120, since an excessive layer of the silicon oxide film 130 is left on the surface as shown in FIG. 3C, the excessive layer of the silicon oxide film 130 is removed by CMP, thereby exposing the surface of the nitride film 110 (see FIG. 3D). Then, the nitride film 110 is etched away, thus forming a groove 130a of the silicon oxide film (see FIG. 3E). A transistor 140 is then formed using such groove 130a of the silicon oxide film (see FIG. 3F).

In the STI forming process described above, the purpose of the polishing step using CMP is to completely remove the excessive silicon oxide film formed on the nitride film. If the excessive silicon oxide film is not removed completely, then the subsequent etching of the nitride film will be impaired.

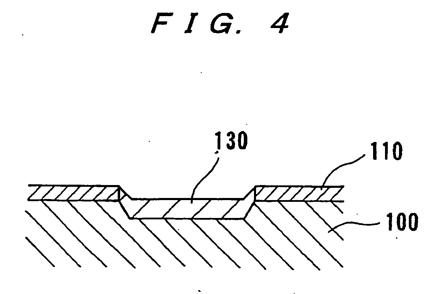

However, the polishing step in the above-mentioned conventional STI forming process employs a polyurethane-based polishing pad and a slurry with silica abrasive particles dispersed therein. Since the nitride film 110 is less liable to be polished than the silicon oxide film 130, the silicon oxide film 130 is excessively polished, thus developing dishing as shown in FIG. 4. Furthermore, the nitride film tends to be polished unevenly, resulting in insufficient within-wafer uniformity. In the STI forming process, it is necessary to strictly control the thicknesses of the nitride film and the silicon oxide film in the trench, i.e., to uniformize the film thickness within the surface of the wafer, and it is important to suppress dishing for within-wafer uniformity.

Recently, it has been attempted to solve the above problems by polishing wafers using a polyurethane-based polishing pad and a slurry with ceria abrasive particles dispersed therein, while adding a trace amount of a high concentration surface-active agent. If the dishing amount developed using a silica slurry is 500Å, for example, then the dishing amount can be reduced to a range from 200 to 300Å by this process. However, this process cannot eliminate the above dishing completely because it also uses the soft polishing pad. Another problem of this process is that the high concentration surface-active agent causes ceria to agglomerate, and that the agglomerated ceria scratches the wafer.

In an effort to solve the problems of the polishing processes using an abrasive liquid (slurry) containing abrasive particles and a soft polishing pad, there has been proposed a polishing process using a fixed abrasive as disclosed in Japanese laid-open patent publication No. 2000-173955. Specifically, in Japanese laid-open patent publication No. 2000-173955, there has been proposed a process for polishing a wafer with a fixed abrasive containing ceria and a polishing liquid which contains 1% by weight of ammonium polyacrylate having a molecular weight of 10000, and has an alkaline pH value. The purpose of this process is to increase the polishing rate by making the pH alkaline to sufficiently increase the dispersion of dropped abrasive particles. However, because ammonium polyacrylate to be added has a relatively high concentration, aggregation is liable to occur, and hence it is difficult to sufficiently prevent scratches from occurring. Further, since the pH is alkaline, it is difficult to suppress dishing and obtain good within-wafer uniformity.

As the prior art is concerned further attention is drawn to US-A-2002/28581 a family member of prepublished JP-A-2002-43256 which discloses a polishing method for polishing a workpiece by pressing the workpiece to be polished against a grindstone using a process solution containing a dispersant. Adding the dispersant in the process using the grindstone improves the polishing selectivity with respect to the kind of films to obtain excellent planarizing and a good process quantity uniformity as well as the stability of process and the controllability.

US-A-5,990,012 discloses a method of chemical-mechanical polishing of a surface on a semiconductor substrate providing a fixed-abrasive polishing pad; providing a surface to be polished; and providing a chemical polishing solution containing a surface tension-lowering agent that lowers the surface tension of the solution from the nominal surface tension of water to a surface tension that sufficiently wets a hydrophobic surface to be polished such that chemical-mechanical polishing is accomplished.

A polishing method as set forth in claim 1 and a polishing liquid as set forth in claim 4 is provided. Preferred embodiments of the invention are disclosed in the dependent claims.

### Disclosure of Invention

The present invention has been made in view of the above problems in the prior art. It is therefore an object of the present invention to provide a polishing method and a polishing liquid which can suppress dishing in a workpiece having a nitride film and an oxide film formed on the nitride film, and obtain within-wafer uniformity.

In order to solve the problems in the prior art, according to a first aspect of the present invention, there is provided a polishing method for polishing a workpiece by pressing the workpiece to be polished against a fixed abrasive and bringing the workpiece in sliding contact with the fixed abrasive, the polishing method comprising: polishing the workpiece while supplying a polishing liquid which contains an anionic surface-active agent and does not contain abrasive particles.

The concentration of the anionic surface-active agent in the polishing liquid is 0.001 % by weight to 0.15 % by weight. The pH of the polishing liquid is 4 to 6.5. Further, the anionic surface-active agent preferably contains an organic compound having a hydrophilic group selected from COO⁻ group and SO₃⁻ group. Further, the workpiece preferably has a nitride film and a silicon oxide film deposited on the nitride film.

Furthermore, the anionic surface-active agent is preferably polyacrylic acid and/or its salt having a weight average molecular weight of not less than 13000 and not more than 60000.

In the neutral to acidic pH region of the polishing liquid, the surfaces of the abrasive particles of the fixed abrasive and the surface of the nitride film are principally charged positively (though part of the surfaces possess a negative charge, a positive charge is predominant). Accordingly, the anionic surface-active agent supplied onto the fixed abrasive strongly adheres to the surfaces of the abrasive particles of the fixed abrasive and to the surface of the nitride film electrically. Since the abrasive particles of the fixed abrasive and the nitride film are both covered with the anionic surface-active agent to interact repulsively. Therefore, polishing of the nitride film is hard to proceed and the polishing rate of the nitride film becomes extremely low. The polishing selectivity is, for example, oxide film : nitride film = 10 or higher : 1, and the nitride film acts as a polishing stopper. Since the polishing rate of the nitride film is extremely lowered and stock removal decreases, the resulting nitride film can be prevented from becoming uneven in the film thickness and within-wafer uniformity of the nitride film can be obtained.

At this point, it may be considered that because of the above-described polishing selectivity, the nitride film is not polished and only the silicon oxide film is polished, and the above-described dishing will proceed. In fact, however, dishing does not proceed, and depth of the dishing amount can be controlled, for example, within 100 Å or less. This is considered to be due to the following reasons:
① The anionic surface-active agent adheres not only to the surface of the nitride film, but also to the silicon oxide film in small amount, whereby a coat of the anionic surface-active agent is formed on the surface of the silicon oxide film. When a surface pressure having a certain value or more is applied to the silicon oxide, a coat on the surface of the silicon oxide film breaks or becomes fragile, and therefore polishing of the silicon oxide film proceeds. As the polishing proceeds to a certain extent, however, the level of the surface of the silicon oxide film becomes lower than that of the nitride film. Accordingly, the surface pressure on the silicon oxide film decreases, and hence a coat of the anionic surface-active agent is formed thick on the silicon oxide film and the progress of polishing is retarded.
② Since the anionic surface-active agent used here is a polymer, the anionic surface-active agent, which has adhered to the nitride film, covers part or a considerable area of the trench portion, and hence polishing of the silicon oxide film by the abrasive particles in the fixed abrasive is impeded.

Further, according to the polishing method of the present invention, the concentration of the anionic surface-active agent in the polishing liquid is made low so that the abrasive particles, which have dropped out of the fixed abrasive, do not agglomerate and thus the formation of scratches can be reduced.

Further, the present invention uses a fixed abrasive as a polishing surface. A fixed abrasive provides a hard polishing surface which hardly deforms elastically. Such a polishing surface, as compared to a conventional polishing pad having elasticity, is less likely to cause dishing and can provide a flatter finished surface.

Thus, according to the present invention, polishing of a workpiece is carried out while supplying the polishing liquid which contains an anionic surface-active agent at a low concentration and does not contain abrasive particles, and has an acidic pH, onto the fixed abrasive, whereby a nitride film, for example, is allowed to act as a polishing stopper. Accordingly, the polishing method of the present invention can lower the polishing rate of a nitride film to obtain within-wafer uniformity of the nitride film and can suppress dishing, thus enabling a high-flatness polishing with fewer scratches.

### Brief Description of Drawings

FIG. 1 is a plan view showing an overall construction of a polishing apparatus ;
FIG. 2 is a front view of the polishing chamber of FIG. 1;
FIGS. 3A through 3F are schematic views showing an example of an STI forming process; and
FIG. 4 is a schematic view showing dishing caused by a polishing apparatus.

### Best Mode for Carrying Out the Invention

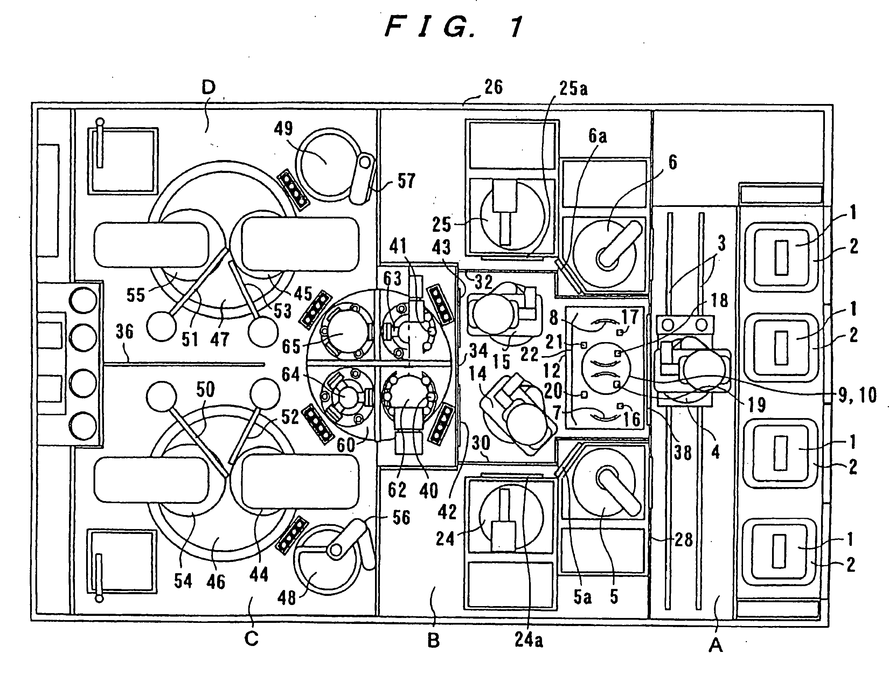

A polishing apparatus will be described in detail below with reference to the drawings. FIG. 1 is a plan view showing a whole arrangement of a polishing apparatus.

As shown in FIG. 1, the polishing apparatus comprises four load/unload stages 2 each for receiving a wafer cassette 1 which accommodates a number of semiconductor wafers. The load/unload stages 2 may have a lifting and lowering mechanism. A transfer robot 4 is provided on rails 3 so that the transfer robot 4 can access the respective wafer cassettes 1 on the respective load/unload stages 2.

The transfer robot 4 has upper and lower hands. The lower hand of the transfer robot 4 is a vacuum attraction-type hand for holding a semiconductor wafer under vacuum, and is used only for removing a semiconductor wafer from a wafer cassette 1. The vacuum attraction-type hand can hold and transport the semiconductor wafer even if the semiconductor wafer is not located at a normal position in the wafer cassette due to a slight displacement. The upper hand of the transfer robot 4 is a recess support-type hand for supporting a peripheral edge of a wafer, and is used only for returning the semiconductor wafer to the wafer cassette 1. The recess support-type hand can transport the semiconductor wafer while keeping the semiconductor wafer clean because dust is not collected, unlike the vacuum attraction-type hand. In this manner, since a clean wafer which has been cleaned is held by the upper hand, the clean semiconductor wafer is not further contaminated.

Two cleaning units 5, 6 for cleaning a semiconductor wafer are disposed at an opposite side of the wafer cassettes 1 with respect to the rails 3 of the transfer robot 4. The cleaning units 5, 6 are disposed at positions accessible by the hands of the transfer robot 4. Each of the cleaning units 5, 6 has a spin-dry mechanism for drying a wafer by spinning the wafer at a high speed, and hence two-stage cleaning and three-stage cleaning of a wafer can be performed without replacing any cleaning module.

Between the two cleaning units 5 and 6, a wafer station 12 having four semiconductor wafer supports 7, 8, 9 and 10 is disposed at a position accessible by the transfer robot 4. A transfer robot 14 having two hands is disposed at a position where hands of the transfer robot 14 can access the cleaning unit 5 and the three supports 7, 9 and 10. A transfer robot 15 having two hands is disposed at a position where hands of the transfer robot 15 can access the cleaning unit 6 and the three supports 8, 9 and 10.

The support 7 is used to transfer a semiconductor wafer between the transfer robot 4 and the transfer robot 14, and the support 8 is used to transfer a semiconductor wafer between the transfer robot 4 and the transfer robot 15. These supports 7, 8 have sensors 16, 17 for detecting existence of a semiconductor wafer, respectively.

The support 9 is used to transfer a semiconductor wafer from the transfer robot 15 to the transfer robot 14, and the support 10 is used to transfer a semiconductor wafer from the transfer robot 14 to the transfer robot 15. These supports 9, 10 have sensors 18, 19 for detecting existence of a semiconductor wafer, and rinsing nozzles 20, 21 for preventing the semiconductor wafer from being dried or rinsing the wafer.

The supports 9 and 10 are disposed in a common water-scatter-prevention cover which has an opening defined therein for transferring wafers therethrough. At the opening, there is provided a shutter 22. The support 9 is disposed above the support 10. The upper support 9 serves to support a wafer which has been cleaned, and the lower support 10 serves to support a wafer to be cleaned. With this arrangement, the wafer is prevented from being contaminated by rinsing liquid which would otherwise fall thereon. The sensors 16, 17, 18 and 19, the rinsing nozzles 20, 21, and the shutter 22 are schematically shown in FIG. 1, and their positions and shapes are not exactly illustrated.

A cleaning unit 24 is disposed at a position adjacent to the cleaning unit 5 and is accessible by the hands of the transfer robot 14. Further, a cleaning unit 25 is disposed at a position adjacent to the cleaning unit 6 and is accessible by hands of the transfer robot 15. These cleaning units 24 and 25 are capable of cleaning both surfaces of a wafer.

The respective upper hands of the transfer robot 14 and the transfer robot 15 are used for transporting a semiconductor wafer that has been cleaned to the cleaning units or the supports of the wafer station 12. On the other hand, the respective lower hands of the transfer robot 14 and the transfer robot 15 are used for transporting a semiconductor wafer that has not cleaned or a semiconductor wafer to be polished. Since the lower hands are used to transfer a wafer to or from a reversing device (described later on), the upper hands are not contaminated by drops of rinsing liquid which fall from an upper wall of the reversing device.

As shown in FIG. 1, the cleaning units 5, 6, 24 and 25 have shutters 5a, 6a, 24a and 25a at respective wafer entrances for transferring wafers therethrough, respectively. The shutters 5a, 6a, 24a and 25a are opened only when wafers are transferred through the shutters 5a, 6a, 24a and 25a.

The polishing apparatus has a housing 26 for enclosing various components therein. An interior of the housing 26 is partitioned into a plurality of areas (including areas A and B) by partition walls 28, 30, 32, 34 and 36.

Area A in which the wafer cassettes 1 and the transfer robot 4 are disposed, and area B in which the cleaning units 5 and 6 and the supports 7, 8, 9 and 10 are disposed, are partitioned by the partition wall 28 so that cleanliness of area A and area B can be separated from each other. The partition wall 28 has an opening for transferring semiconductor wafers between area A and area B, and a shutter 38 is provided at the opening of the partition wall 28. All of the cleaning units 5, 6, 24 and 25, the supports 7, 8, 9 and 10 of the wafer station 12, and the transfer robots 14 and 15 are placed in area B. Pressure in area B is adjusted so as to be lower than pressure in area A.

As shown in FIG. 1, in area C separated from area B by the partition wall 34, a reversing device 40 for reversing a semiconductor wafer is provided at a position accessible by the hands of the transfer robot 14. The semiconductor wafer is transferred to the reversing device 40 by the transfer robot 14. Further, in area C, a reversing device 41 for reversing a semiconductor wafer is provided at a position accessible by the hands of the transfer robot 15. The semiconductor wafer is transferred to the reversing device 41 by the transfer robot 15. Each of the reversing devices 40 and 41 has a chuck mechanism for chucking a semiconductor wafer, a reversing mechanism for reversing the semiconductor wafer, and a detecting sensor for detecting whether or not the chuck mechanism chucks the semiconductor wafer.

The partition wall 34 forms a polishing chamber which is separated from area B. The polishing chamber is further divided into two areas C and D by the partition wall 36. The partition wall 34 between area B and areas C, D has openings for transferring semiconductor wafers therethrough. Shutters 42, 43 for the reversing devices 40, 41 are respectively provided at the openings of the partition wall 34.

As shown in FIG. 1, each of areas C and D has two polishing tables and one top ring for holding and pressing one semiconductor wafer against the polishing tables to polish the wafer. Specifically, area C has a top ring 44, polishing tables 46, 48, a polishing liquid supply nozzle 50 for supplying a polishing liquid onto the polishing table 46, an atomizer 52 having a plurality of ejection nozzles (not shown) connected to a nitrogen gas supply source and a liquid supply source, a dresser 54 for dressing the polishing table 46, and a dresser 56 for dressing the polishing table 48. Similarly, area D has a top ring 45, polishing tables 47, 49, a polishing liquid supply nozzle 51 for supplying a polishing liquid onto the polishing table 47, an atomizer 53 having a plurality of ejection nozzles (not shown) connected to a nitrogen gas supply source and a liquid supply source, a dresser 55 for dressing the polishing table 47, and a dresser 57 for dressing the polishing table 49.

The polishing liquid supply nozzles 50, 51 supply polishing liquids, used for a polishing process, and dressing liquids (e.g., water) used for a dressing process, onto the polishing tables 46, 47, respectively. The atomizers 52, 53 eject liquids composed of a mixture of nitrogen gas with pure water or a chemical liquid onto the polishing tables 46, 47, respectively. Nitrogen gas from the nitrogen gas supply source and pure water or a chemical liquid from the liquid supply source are passed through a regulator or air operated valve (not shown) to regulate pressure thereof to a predetermined value, and supplied to the ejection nozzles in the atomizers 52, 53 in a mixed state. In this case, the liquid should preferably be ejected from the ejection nozzles of the atomizers 52, 53 toward outer peripheral edges of the polishing tables 46, 47. Other inert gases may be used instead of nitrogen gas. Further, the atomizers 52, 53 may eject only a liquid of pure water or a chemical liquid. The polishing tables 48, 49 may have atomizers as with the polishing tables 46, 47, respectively. With atomizers for the polishing tables 48, 49, surfaces of the polishing tables 48, 49 can be kept clean.

The mixture of nitrogen gas with pure water or the chemical liquid is supplied in a state of ① liquid fine particles, ② solid fine particles as a result of solidification of the liquid, or ③ gas as a result of vaporization of the liquid. These states ①, ② and ③ are referred to as atomization. In these states, the mixture is ejected from the ejection nozzles of the atomizers 52, 53 toward the polishing tables 46, 47. For example, pressure or temperature of the nitrogen gas and/or the pure water or the chemical liquid, or the shape of the nozzles determines which state of the mixed liquid is to be ejected, i.e., the liquid fine particles, the solid fine particles, or gas. Therefore, the state of the liquid to be ejected can be varied, for example, by properly adjusting pressure or temperature of the nitrogen gas and/or the pure water or the chemical liquid with use of a regulator or the like, or by properly adjusting the shape of the nozzles.

The polishing tables 48, 49 may be replaced with wet-type thickness measuring devices for measuring a thickness of a film formed on a wafer. With such wet-type thickness measuring devices, the thickness of a film formed on a wafer can be measured immediately after the wafer is polished, and hence it is possible to further polish the polished wafer or to control a polishing process for polishing a subsequent wafer based on measured results.

A rotary transporter 60 is disposed below the reversing devices 40 and 41 and the top rings 44 and 45 to transfer wafers between the cleaning chamber (area B) and the polishing chamber (areas C, D). The rotary transporter 60 has four stages for placing wafers W at equal angular intervals, and can hold a plurality of wafers thereon at the same time.

A wafer which has been transferred to the reversing device 40 or 41 is transferred to the rotary transporter 60 by elevating and lowering a lifter 62 or 63 disposed below the rotary transporter 60 when a center of a stage of the rotary transporter 60 is aligned with a center of the wafer held by the reversing device 40 or 41. A wafer placed on the stage of the rotary transporter 60 is transported to a position below the top ring 44 or the top ring 45 by rotating the rotary transporter 60 by an angle of 90°. At this time, the top ring 44 or the top ring 45 is positioned above the rotary transporter 60 beforehand by a swinging motion of the top ring. A wafer held on the stage of the rotary transporter 60 is transferred to the top ring 44 or 45 by elevating and lowering a pusher 64 or 65 disposed below the rotary transporter 60 when a center of the top ring 44 or 45 is aligned with a center of the wafer.

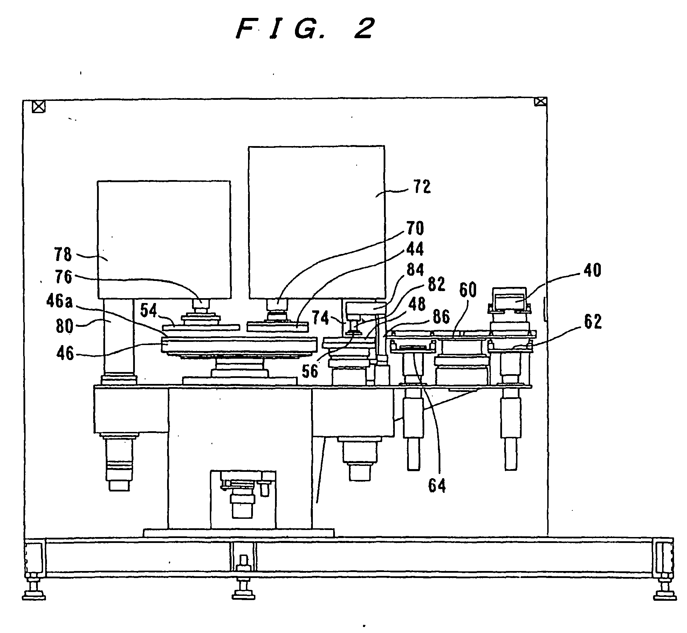

Next, the polishing chamber will be described below. Although only area C will be described below, the following description can be applied to area D. FIG. 2 shows a relationship between the top ring 44 and the polishing tables 46, 48 in area C.

As shown in FIG. 2, the top ring 44 is supported from a top ring head 72 by a top ring drive shaft 70 which is rotatable. The top ring head 72 is supported by a support shaft 74 which can angularly be positioned, and the top ring 44 can access the polishing tables 46 and 48.

The dresser 54 is supported from a dresser head 78 by a dresser drive shaft 76 which is rotatable. The dresser head 78 is supported by a support shaft 80 which can angularly be positioned, and the dresser 54 can be moved between a standby position and a dressing position above the polishing table 46. The dresser 56 is similarly supported from a dresser head 84 by a dresser drive shaft 82 which is rotatable. The dresser head 84 is supported by a support shaft 86 which can angularly be positioned, and the dresser 56 can be moved between a standby position and a dressing position above the polishing table 48.

The polishing table 46 has an upper surface composed of a fixed abrasive 46a having abrasive particles and pores or a pore agent, which are fixed by a binder (resin). The fixed abrasive 46a serves as a polishing surface for polishing a semiconductor wafer held by the top ring 44. Such a fixed abrasive 46a can be obtained, for example, by spray-drying a mixed liquid which is a mixture of a slurry of abrasive (dispersion of abrasive particles in a liquid) and a resin emulsion, filling the resulting mixed powder into a molding jig, and subjecting the mixed powder to a pressure/heat treatment. Ceria (CeO₂) or silica (SiO₂) having an average particle diameter of not more than 0.5 µm is preferably used as the abrasive particles. A thermoplastic resin or a thermosetting resin may be used as the binder. The thermoplastic resin is preferably used.

The polishing table 48 has an upper surface composed of a soft nonwoven fabric. The nonwoven fabric serves as a cleaning surface for cleaning a semiconductor wafer after a polishing process to remove abrasive particles attached to a surface of the semiconductor wafer.

Next, a polishing process for polishing a semiconductor wafer with the use of a polishing apparatus described above will be described below. Although a polishing process only in area C will be described below, the following description can be applied to a polishing process in area D. Further, though the following description illustrates application of the present invention to a polishing step in an STI formation, the present invention is also applicable, for example, to polishing of a semiconductor wafer having a pattern of interlayer dielectrics (ILD).

### 1) Polishing process

While the polishing table 46 and the top ring 44 are rotated about their own axes, respectively, a semiconductor wafer is pressed against the polishing table 46 to thereby polish a silicon oxide film on the semiconductor wafer until the fixed abrasive reaches a nitride film. During the polishing, a polishing liquid which contains an anionic surface-active agent and does not contain abrasive particles is supplied from the polishing liquid supply nozzle 50 onto the fixed abrasive 46a. The concentration of the anionic surface-active agent is 0.001 % by weight to 0.15 % by weight. From the viewpoints of suppressing dishing to obtain within-wafer uniformity and dispersing abrasive particles, which have dropped out of the fixed abrasive, to prevent scratches, the concentration is more preferably not less than 0.002 % by weight, further more preferably not less than 0.003 % by weight, and especially preferably not less than 0.004 % by weight. Further, from the viewpoints of achieving a sufficiently high polishing rate and dispersing the dropped abrasive particles to prevent scratches, the concentration is less than 0.15 % by weight, more preferably less than 0.10 % by weight, further more preferably less than 0.08 % by weight, especially preferably less than 0.05 % by weight. Accordingly, the concentration of the anionic surface-active agent is not less than 0.001 % by weight and less than 0.15 % by weight, preferably not less than 0.002 % by weight and less than 0.10 % by weight, more preferably not less than 0.003 % by weight and less than 0.08 % by weight, especially preferably not less than 0.004 % by weight and less than 0.05 % by weight. The purpose of the addition of the surface-active agent is, besides allowing the nitride film to function as a stopper, to control the polishing rate of the silicon oxide film to thereby suppress dishing (in the trench portion). A rise in the concentration of the surface-active agent can lower the polishing rate of the silicon oxide film and can therefore suppress dishing. If the concentration is excessively increased, the polishing rate is extremely lowered, thus requiring a long polishing time. This leads to a lowering of the productivity. For example, when ammonium polyacrylate is added at a concentration of 0.05 % by weight, the polishing rate of the silicon oxide film decreases by about 30 %, as compared to the case of pure water. There is a linear relationship between the surface-active agent concentration and the decrease in the polishing rate. Thus, the polishing rate decreases by about 60 % at a concentration of 0.10 %, and by about 90 % at a concentration of 0.15 %. In consideration of the productivity, it is desirable to set the upper limit of the concentration of the surface-active agent at 0.15 %.

The pH of the polishing liquid is from 4 to 6.5. In particular, from the viewpoint of dispersing dropped abrasive particles to prevent scratches, the pH is preferably over 4.5, more preferably over 4.8, especially preferably over 5.0. Further, from the viewpoint of suppressing dishing to obtain within-wafer uniformity, the pH is more preferably less than 5.5, further preferably less than 5.4, especially preferably less than 5.3. Accordingly, the pH value is preferably higher than 4.5 and less than 5.5, more preferably higher than 4.8 and less than 5.4, especially preferably higher than 5.0 and less than 5.3.

The anionic surface-active agent preferably contains an organic compound having a hydrophilic group which is either a COO⁻ group or a SO₃⁻ group. From the viewpoints of dispersing dropped abrasive particles to prevent scratches and suppressing dishing to obtain within-wafer uniformity, an organic compound having a COO⁻ group is particularly preferred. Specific examples of such organic compounds include: sulfuric acid compounds, such as alkylsulfuric acid, alkyl ether sulfuric acid, and their salts; sulfonic acid compounds, such as alkylsulfonic acid, alkylbenzene sulfonic acid, alkylnaphthalene sulfonic acid, sulfosuccinic acid, a naphthalenesulfonic acid-formalin condensate, lignin sulfonic acid, polystyrene sulfonic acid, and their salts; carboxylic acid compounds, such as a soap, alkyl ether carboxylic acid, polyacrylic acid, polymethacrylic acid, a copolymer containing acrylic acid or metacrylic acid, and their salts; and phosphoric acid compounds, such as alkylphosphoric acid, alkyl ether phosphoric acid, and their salts. Of these compounds, polyacrylic acid and its salts are most preferable. Among polyacrylate, an ammonium salt is preferable.

From the viewpoint of dispersing dropped abrasive particles to prevent scratches, the weight average molecular weight (Mw) of polyacrylic acid and its salt is preferably not less than 13000, more preferably not less than 14000, and most preferably not less than 15000. On the other hand, from the viewpoint of suppressing dishing to obtain within-wafer uniformity, the molecular weight is preferably not more than 60000, more preferably not more than 50000, and most preferably not more than 45000. Accordingly, the molecular weight is preferably not less than 13000 and not more than 60000, more preferably not less than 14000 and not more than 50000, and most preferably not less than 15000 and not more than 45000. The molecular weight values of polyacrylic acid and its salt were measured by gel permeation chromatography (GPC) carried out under the following condition:
Pump: CCPD (Tosoh Corporation)
Detector: RI - 71 (Shodex)
Data processing software: Gpc - 8020 (Tosoh Corporation)
Column: G4000PW_{XL} (Tosoh Corporation) was used as a first-stage column, and G2500PW_{XL} (Tosoh Corporation) was used as a second-stage column
Eluent: A mixture of 0.2 M phosphoric acid buffer solution and CH₃CN in the ratio of 9 : 1 (volume ratio) was used. The 0.2 M phosphoric acid buffer solution is a mixture of 0.2 mol/L aqueous KH₂PO₄ solution and 0.2 mol/L aqueous Na₂HPO₄ solution in the ratio of 1 : 1 (volume ratio).
Flow rate: 1.0 mL/min
Column temperature: 40 °C
Sample amount: Aqueous solution of 0.5 wt% polyacrylic acid and its salt 100 µL
Molecular weight conversion: using seven species of polyethylene glycol with known molecular weights (12000, 26000, 95000, 145000, 250000, 510000, 920000), a calibration curve was prepared for conversion of molecular weight.

It is preferred that the polishing liquid of the present invention contains at least two types of anionic surface-active agents: polyacrylic acid and its salt which, from the viewpoint of dispersing dropped abrasive particles to prevent scratches, has a weight average molecular weight of not less than 25000 and not more than 60000; and polyacrylic acid and its salt which, from the viewpoint of suppressing dishing to obtain within-wafer uniformity, has a weight average molecular weight of not less than 13000 and less than 25000.

The first polyacrylic acid and its salt, has a weight average molecular weight of not less than 25000 and not more than 60000, more preferably has a weight average molecular weight of not less than 27000 and not more than 45000, and most preferably has not less than 28000 and not more than 35000. From the viewpoints of dispersing dropped abrasive particles to prevent scratches and suppressing dishing to obtain within-wafer uniformity, the surface-active agent is added preferably in an amount of not less than 0.0005 % by weight and less than 0.03 % by weight, more preferably not less than 0.001 % by weight and less than 0.02 % by weight, most preferably not less than 0.005 % by weight and less than 0.01 % by weight.

The second polyacrylic acid and its salt, has a weight average molecular weight of not less than 13000 and less than 25000, more preferably has a weight average molecular weight of not less than 14000 and not more than 24000, most preferably has not less than 15000 and not more than 23000. From the viewpoints of suppressing dishing to obtain within-wafer uniformity and achieving a sufficiently high polishing rate, the surface-active agent is added preferably in an amount of not less than 0.003 % by weight and less than 0.12 % by weight, more preferably not less than 0.01 % by weight and less than 0.08 % by weight, most preferably not less than 0.02 % by weight and less than 0.04 % by weight.

The experimental results of polishing of STI substrates (SKW3-1, using MIT964 mask) by using a polishing apparatus according to the present invention which includes a fixed abrasive pad comprising ceria abrasive particles having an average particle diameter of 0.2 µm and a thermoplastic resin as a binder will be described. The following polishing liquids 1, 2 and 3 were used to polish the STI substrates: polishing liquid 1 containing 0.008 % by weight of polyacrylic acid having a molecular weight of 31200 and 0.032 % by weight of polyacrylic acid having a molecular weight of 17700, the pH of the polishing liquid being adjusted to 5.1 with ammonia; polishing liquid 2 containing 1.6 % by weight of polyacrylic acid having a molecular weight of 31200, the pH of the polishing liquid being adjusted to 6.0 with ammonia; and polishing liquid 3 containing 1.0 % by weight of polyacrylic acid having a molecular weight of 31200, the pH of the polishing liquid being adjusted to 9.0 with ammonia. When the STI substrate was polished using the polishing liquid 1, dishing was observed but the depth of dishing was not more than 100 Å, while no scratch was observed, thus good polishing was achieved. When the STI substrate was polished using the polishing liquid 2, though dishing was at the same level as the polishing liquid 1, some scratches were observed. When the STI substrate was polished using the polishing liquid 3, some scratches were observed and no improvement was found in terms of dishing.

In this manner, by polishing a substrate while supplying a polishing liquid which contains not less than 0.001 % by weight and less than 0.15 % by weight of anionic surface-active agent and does not contain abrasive particles and has a pH of 4 to 6.5, onto the fixed abrasive 46a, it becomes possible to allow a nitride film to act as a stopper, as described above. Accordingly, the polishing rate of the nitride film can be lowered to thereby obtain within-wafer uniformity of the nitride film and dishing of an oxide film can be suppressed. A high-flatness polishing with fewer scratches can thus be effected.

As described above, according to the present invention, a workpiece is polished while supplying the polishing liquid which contains an anionic surface-active agent at a low concentration of not less than 0.001 % by weight and less than 0.15 % by weight and does not contain abrasive particles and has a pH of 4 to 6.5, onto a fixed abrasive. This makes it possible to allow a nitride film, for example, to act as a polishing stopper. Accordingly, the present invention makes it possible to lower the polishing rate of a nitride film, thereby obtaining within-wafer uniformity of the nitride film, and to suppress dishing, thus enabling a high-flatness polishing with fewer scratches.

### Industrial Applicability

The present invention can be advantageously applied to a polishing method and a polishing liquid for polishing a workpiece such as a semiconductor wafer by using a fixed abrasive.

## Claims

1. A polishing method for polishing a workpiece by pressing the workpiece to be polished against a fixed abrasive and bringing the workpiece in sliding contact with the fixed abrasive, the polishing method comprising:
polishing the workpiece while supplying a polishing liquid which contains an anionic surface-active agent and does not contain abrasive particles, **characterised in that** the pH of said polishing liquid is 4 to 6.5 ; and that
the concentration of said anionic surface-active agent in said polishing liquid is 0.001 % by weight to 0.15 % by weight.

2. A polishing method according to claim 1 , wherein said anionic surface-active agent contains an organic compound having a hydrophilic group selected from COO⁻ group and SO₃⁻ group.

3. A polishing method according to claim 1 or 2, wherein said workpiece has a nitride film and a silicon oxide film deposited on the nitride film.

4. A polishing liquid for use in a polishing method for polishing a workpiece by pressing the workpiece to be polished against a fixed abrasive and bringing the workpiece in sliding contact with the fixed abrasive wherein said polishing liquid contains no abrasive particles said polishing liquid being **characterized by** an anionic surface-active agent at a concentration of not less than 0.001 % by weight and less than 0.15 % by weight; and by a pH of 4 to 6.5

5. A polishing liquid according to claim 4, wherein said anionic surface-active agent is polyacrylic acid and/or its salt having a weight average molecular weight of not less than 13000 and not more than 60000.

## Patentansprüche

1. Polierverfahren zum Polieren eines Werkstücks durch Pressen des zu polierenden Werkstücks gegen ein feststehendes Abriebmittel und **dadurch**, dass das Werkstück in Gleitkontakt mit dem feststehenden Abriebmittel gebracht wird, wobei das Polierverfahren Folgendes aufweist: Polieren des Werkstücks während eine Polierflüssigkeit zugeführt wird, die ein anionisches oberflächenaktives Agens und keine Abriebteilchen enthält, **dadurch gekennzeichnet, dass** der pH-Wert der Polierflüssigkeit 4 - 6,5 beträgt, und dass die Konzentration des anionischen oberflächenaktiven Agens in der Polierflüssigkeit 0,001 Gewichtsprozent bis 0,15 Gewichtsprozent ist.

2. Polierverfahren nach Anspruch1, wobei das anionische oberflächenaktive Agens eine organische Verbindung enthält, und zwar mit einer hydrophilen Gruppe ausgewählt aus folgenden Gruppen:
COO⁻ Gruppe und SO₃⁻ Gruppe.

3. Polierverfahren nach Anspruch 1 oder 2, wobei das Werkstück eine Nitritschicht oder einen Nitritfilm aufweist, und wobei ferner eine Siliziumoxydschicht oder -film über der Nitritschicht abgeschieden ist.

4. Polierflüssigkeit zur Verwendung in einem Polierverfahren zum Polieren eines Werkstücks durch Pressen des zu polierenden Werkstücks gegen ein festes Abriebmittel und **dadurch**, dass das Werkstück in Gleitkontakt mit dem feststehenden Abriebmittel gebracht wird, wobei die Polierflüssigkeit keine Abriebteilchen enthält und wobei die Polierflüssigkeit **gekennzeichnet ist durch** ein anionisches oberflächenaktives Agens mit einer Konzentration von nicht weniger als 0,01 Gewichtsprozent und weniger als 0,15 Gewichtsprozent, und ferner **gekennzeichnet durch** eine pH-Wert von 4 bis 6,5.

5. Polierflüssigkeit nach Anspruch 4, wobei das anionische oberflächenaktive Agens Polyacrylsäure und/oder ihr Salz mit einem durchschnittlichem Molekulargewicht von nicht weniger als 13000 und als nicht mehr als 60000 ist.

## Revendications

1. Procédé de polissage pour polir une pièce en comprimant la pièce destinée à être polie contre un abrasif fixe et en mettant la pièce en contact coulissant avec l'abrasif fixe, le procédé de polissage comprenant les étapes consistant à :
polir la pièce tout en fournissant un liquide de polissage qui contient un agent tensioactif anionique et ne contient pas de particules abrasives, **caractérisé en ce que** le pH dudit liquide de polissage est de 4 à 6,5 ; et que
la concentration dudit agent tensioactif anionique dans ledit liquide de polissage est de 0,001 % en poids à 0,15 % en poids.

2. Procédé de polissage selon la revendication 1, dans lequel ledit agent tensioactif anionique contient un composé organique
possédant un groupe hydrophile sélectionné parmi le groupe COO⁻ et le groupe S0₃⁻.

3. Procédé de polissage selon la revendication 1 ou 2, dans lequel ladite pièce possède un film de nitrure et un film d'oxyde de silicium déposé sur le film de nitrure.

4. Liquide de polissage destiné à être utilisé dans le procédé de polissage pour polir une pièce en comprimant la pièce destinée à être polie contre un abrasif fixe et en mettant la pièce en contact coulissant avec l'abrasif fixe dans lequel ledit liquide de polissage ne contient aucune particule abrasive, ledit liquide de polissage étant **caractérisé par** un agent tensioactif anionique à une concentration non inférieure à 0,001 % en poids et inférieure à 0,15 % en poids ; et par un pH de 4 à 6,5.

5. Liquide de polissage selon la revendication 4, dans lequel ledit agent tensioactif anionique est un acide polyacrylique et/ou son sel possédant un poids moléculaire moyen pondéral non inférieur à 13000 et non supérieur à 60000.
